Europäisches Patentamt

European Patent Office

Office européen des brevets

(19)

(11) Publication number: **0 203 203**
**A1**

## EUROPEAN PATENT APPLICATION

published in accordance with Art. 158(3) EPC

(21) Application number: **85906086.5**

(22) Date of filing: **28.11.85**

Data of the international appli-
cation taken as a basis:

(86) International application number:
**PCT/JP 85/00660**

(87) International publication number:
**WO 86/03364 (05.06.86 86/12)**

(51) Int. Cl.⁴: **H 05 K 1/02, H 05 K 3/46**

(30) Priority: **29.11.84 JP 253561/84**

(43) Date of publication of application: **03.12.86**
**Bulletin 86/49**

(84) Designated Contracting States: **CH DE FR GB IT LI NL SE**

(71) Applicant: **FUJITSU LIMITED, 1015, Kamikodanaka
Nakahara-ku, Kawasaki-shi Kanagawa 211 (JP)**

(72) Inventor: **KUWABARA, Kiyoshi Fujitsu Nagatsuta
Shataku 202, 5-4, Ibukino Midori-ku, Yokohama-shi,
Kanagawa 227 (JP)**
Inventor: **NISHIHARA, Mikio Kopo Masaki 201, 3-12-7,
Kyodo Setagaya-ku, Tokyo 156 (JP)**

(74) Representative: **Sunderland, James Harry et al,
HASELTINE LAKE & CO Hazlitt House 28 Southampton
Buildings Chancery Lane, London WC2A 1AT (GB)**

(54) **MULTI-LAYER SUBSTRATE FOR PRINTED CIRCUIT.**

(57) A multi-layer substrate for printed circuit which has a
pattern (6) for reconstruction in an inner layer, wherein the
pattern (6) for reconstruction is connected to bonding pads
(3g, 3h) for reconstruction on the surface through the inter-
mediary of through holes (5e, 5f).

EP 0 203 203 A1

DESCRIPTION

MULTILAYERED PRINTED CIRCUIT BOARD

TECHNICAL FIELD

The present invention relates to a multilayered printed circuit board in which a plurality of integrated circuits are mounted and particularly to a multilayered printed circuit board which can easily realize modification in such cases that a pattern defect is generated at the internal layers of said circuit board or circuit alteration is carried out.

BACKGROUND ART

Since recent printed circuit board mounts many integrated circuits, the circuit board is multilayered and circuit pattern formed on each layer is complicated.

Therefore, a number of times of modifications of said printed circuit board as a measure for troubles and due to design change, etc. is more and more increasing.

However, there is no decisive method for modification of said printed circuit board and such modifications have been carried out by cutting of the pattern to be modified and addition of wirings for modifications.

Such method not only results in indecent finish but also creates deterioration of reliability in working due to increase of a number of wirings and a secondary obstacle such as an interference of signals between the wires.

Therefore, it is expected to develop a method of modification for a multilayered printed circuit board which realizes easily and accurately modification of multilayered printed circuit board without depending on external wirings in large scale.

DISCLOSURE OF INVENTION

It is an object of the present invention to provide a multilayered printed circuit board which can solve the problems of the prior art in modification of a printed circuit board, namely various obstacles brought about by increase of wirings to be modified.

The object described above of the present invention can be attained by a multilayered printed circuit board mounting integrated circuits wherein modification patterns are provided in the internal layers and bonding pads are provided at the surface which is connected to said modifiction patterns through the through-holes.

Namely, a multilayered printed circuit board of the present invention prepares modification patterns having the same electrical characeristics as the signal layers at the internal layers of the printed circuit board. When modification is requried, said modification patterns are used. In case In case an original pattern is disabled due to defects, a new circuit can be formed with said modification pattern.

BRIEF DESCRIPTION OF DRAWINGS

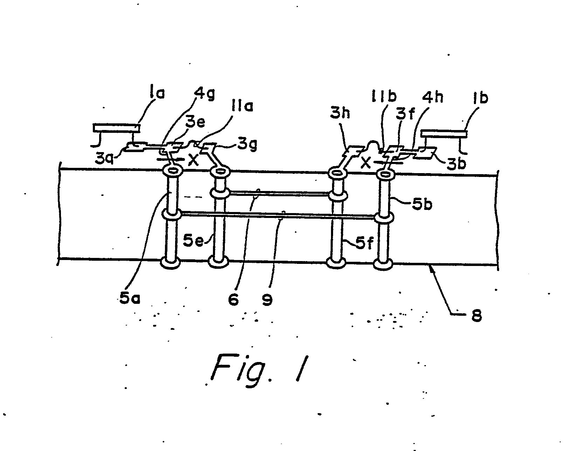

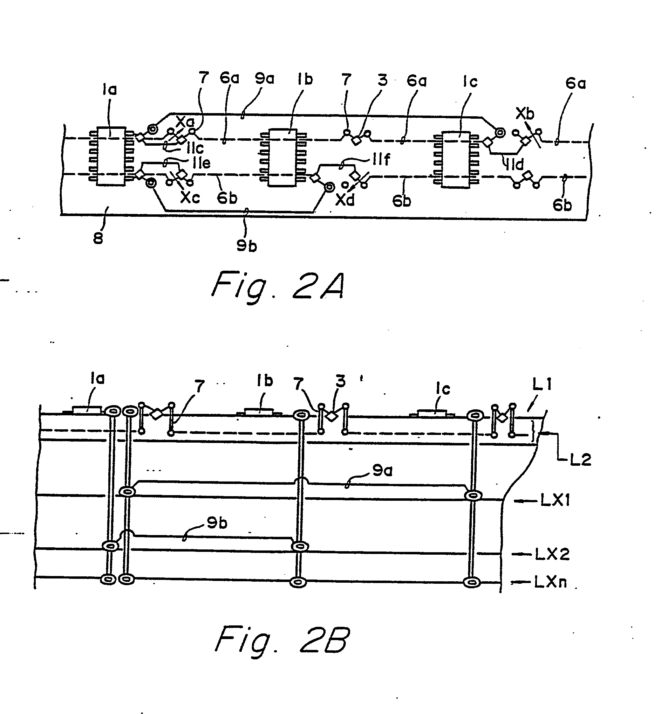

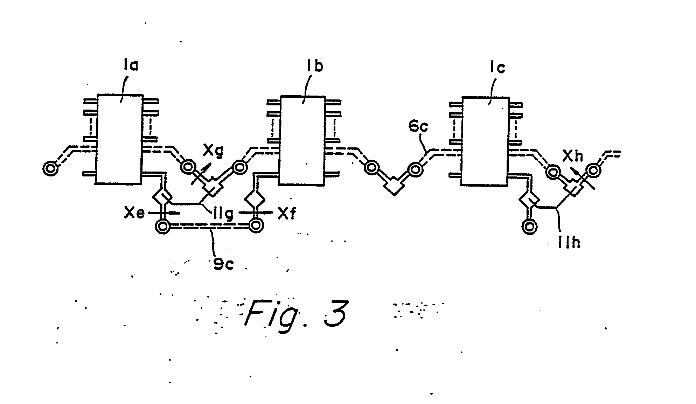

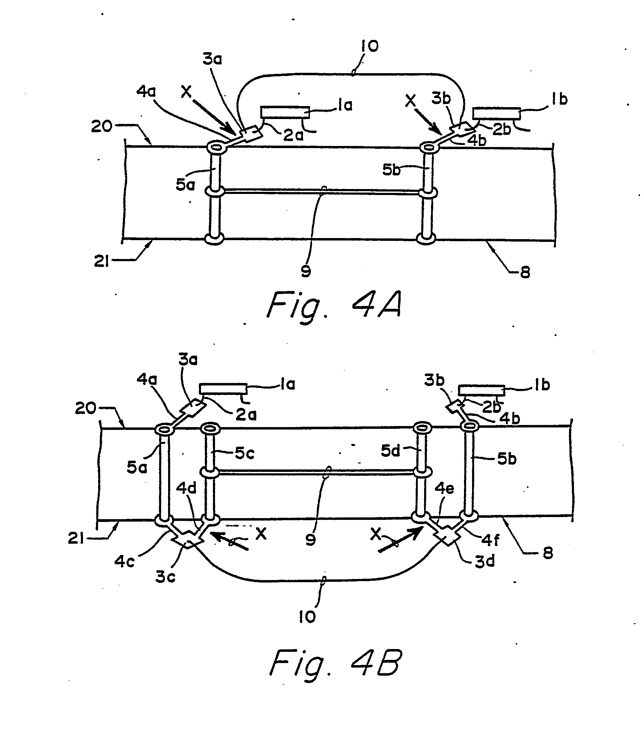

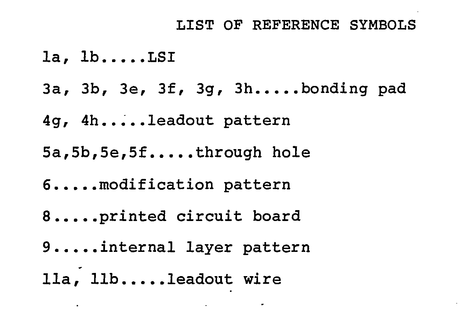

Fig. 1 is a perspective view of side sectional view for explaining a multilayered printed circuit board of the present invention. Fig. 2A is a plan view indicating an example of a circiuit structure. Fig. 2B is a side sectional view of an example of circuit structure shown in Fig. 2A. Fig. 3 is a plan view indicating another example of circuit structure. Fig. 4A is a perspective view of essential part for explaining modification of multilayer printed circuit board of prior art which shows modification at the front surface side. Fig. 4B is a perspective view of essential part for explaining modification of multilayered printed circuit board of prior art which shows modification at the rear surface side.

BEST MODE OF CARRYING OUT THE INVENTION

First, a multilayered printed circuit board which is a root of the present invention is explained with reference to Fig. 4.

Fig. 4 is a perspective view of essential part for explaining modification of a multilayered printed circuit board of the prior art. Fig. 4A shows a modification method at the front surface side, while Fig. 4B shows a modification method at the rear surface side. In the structure of Fig. 4A, LSI's 1a,1b are mounted at the front surface side 20 of a printed circuit board 8 and these LSI's are connected by a lead 2a, a bonding pad 3a, a leadout pattern 4a, a through hole 5a, an internal layer pattern 9, a thorugh hole 5b, a leadout pattern 4b, a bonding pad 3b and a lead 2b.

In case a trouble occurs in the internal layer pattern 9 by some reasons and it is required to eliminate said pattern 9 from the circuit structure of a printed circuit board 8, carried out is such a general substrate modification that the leadout patterns 4a, 4b connecting the through holes 5a, 5b and bonding pads 3a, 3b are cut in the direction X indicated by the arrow mark and relevant bonding pads 3a, 3b are connected at the outside of board by a modification wire 10.

However, in such method, longer wires 10 are laied on the front and rear surfaces of circuit board 8 with increase in amount of said modification wires 10. Thereby, modification works become difficult and working efficiency is also remarkably lowered.

In addition, with increase in amount, the modification wires 10 covers as much the surface of printed circuit board, interfering reliability of working and gives adverse effect to the succeeding inspection and test processes.

Fig. 4B shows said modification carried out at the rear surface side 21 of the circuit board 8 because there is no modification space at the front surface side 20 of the printed circuit board 8.

In the structure of Fig. 4B, LSI's 1a, 1b are connected by a lead 2a, a bonding pad 3a, a leadout pattern 4a, a through hole 5a, a leadout pattern 4c, a bonding pad 3c, a leadout pattern 4d, a through hole 5c, an internal layer pattern 9, a through hole 5d, a leadout pattern 4e, a bonding pad 3d, a leadout pattern 4f, a through hole 5b, a leadout pattern 4b, a bonding pad 3b and a lead 2b.

In case of eliminating the internal layer pattern 9, the leadout patterns 4d, 4e are cut in the direction X indicated by the arrow marks and the bonding pads 3c, 3d are wired with a modification wire 10.

The modification method of Fig. 4B is basically not different from Fig. 4A but further requries another through hole.

As described above, in the structure of Fig. 4, the wire 10 covers the front and rear surfaces of circuit board 8, modification work becomes difficult and working efficiency is also lowered distinctively.

The printed circuit board of the present invention has solved the problems described above.

Hereinafter, a preferred embodiment of the present invention shown in Fig.1 to Fig. 3 is explained in detail.

Fig. 1 is a perspective view of a side sectional view for explaining a multilayered printed circuit board of the present invention. In the structure of Fig. 1, LSI's 1a,1b are connected by the bonding pads 3a, 3e, a leadout pattrn 4g, a through hole 5a, an intenal layer pattern 9, a through hole 5b, a leadout pattern 4h and bonding pads 3f, 3b. Moreover, modification pattern 6 and through holes 5e, 5f and bonding pads 3g, 3h for leading out said modification pattern 6 to the surface of circuit board 8 are also provided.

As shown in Fig. 1, the printed circuit board of the present invention has the structure comprising a modification pattern 6 within the board in addition to the intrinsic circuit structure pattern 9. If it is required to form a new circuit in place of said intrinsic circuit structure pattern 9 by some reasons, the circuit of said intrinsic circuit structure pattern 9 is cut and a modification pattern 6 is connected.

Therefore, the circuit board structure of the present invention provides an independent modification pattern 6, modification through holes 5e, 5f connected to said pattern 6 and modification bonding pads 3g, 3h.

Following works are required for making OFF the pattern 9 to be modified and changing it to the modification pattern 6.

1 The leadout patterns 4g, 4h in the side of pattern 9 are cut in the direction X indicates by the arrow marks.

2 The bonding pads 3g, 3h of modification through holes 5e, 5f are connected with the bonding pads 3e, 3f in the side of LSI lead with the leadout wires 11a, 11b.

With the operation 1, the pattern 9 is set to OFF state and with the operation 2, a new circuit using the modification pattern 6 is set to ON.

This circuit structure means that an alternateive circuit of the pattern 9 to be modified can be obtained only by wiring the leadout wires 11a,11b which are too shorter than the conventional modification wire 10 which is considerably long in size.

Fig. 2 is prepared for explaining an embodiment of the present invention. Fig. 2A is a plan view indicating an example of the circuit structure. Fig. 2B is a side sectional view of a circuit structure example shown in Fig. 2A.

In the structure of Fig. 2, the LSI's 1a, 1b, 1c are mounted on the printed circuit board 8, the modification patterns 6a, 6b are provided at the inner layer L2 neares to the surface L1, a pattern 9a is provided at the layer LX 1 and a pattern 9b at the LX2 layer. The LSI's 1a, 1b are connected by the pattern 9b and the LSI's 1a and 1c are connected by the pattern 9a. In addition, the modification patterns 6a, 6b are connected to a plurality of modification bonding pads 3 on the circuit board surface Ll through a plurality of brind through holes 7.

Therefore, in case the pattern 9a of the LXl layer is to be modified, the modification pattern 6a is cut in the directions Xa, Xb shown by the arrow marks at the surface Ll of circuit board and the leadout wires llc, lld are soldered to the bonding pad 3. Modification can also be realized for the pattern 9a of the LX2 layer in the same method as described above.

Namely, in case the pattern 9b is to be modified, the modification pattern 6b is cut in the directions Xc, Xd shown by the arrow marks at the surface Ll of circuit board and the leadout wires lle, llf are soldered to the bonding pad 3.

Fig. 3 is given in oder to explain another embodiment of the pesent invention and shows an example of modification of a pattern in accordance with design change.

In the structure of Fig. 3, the LSI's lla, llb are connected by the internal layer pattern 9c. Here, when design change occurs, connection between LSI la and lb are set OFF and connection between LSI la and lc is required, following processings are carried out.

1 The leadout patterns of LSI's la, lb are cut in the directons Xe, Xf indicated by the arrow marks, and the internal layer 9c is separated thereby.

2 The leadout pattern at the surface of circuit board of condification pattern 6c is cut in the directions Xg, Xh indicated by the arrow marks, and a pattern for connecting the LSI's la and lc can be obtained.

3 The boding pad of modification through hole and bonding pad in the side of LSI lead are connected with the leadout wires 11g, 11h.

As described above, the multilayered printed circuit board of the present invention results in such a excellent effect as is capable of easily realizing modificaiton of printed circuits with a high efficiency by providing a modification pattern in the layers of said circuit board during the processes for manufacturing said printed circuit board.

INDUSTRIAL APPLICABILITY

The multilayered printed circuit board of the present invention can be used for any kind of electronic apparatuses and particularly can be effectively used for a circuit board having a high packing density mounting LSI's.

0203203

- 9 -

CLAIMS

(1) A multilayered printed circuit board comprising modification patterns at the internal layers and modification bonding pads to be connected with said modification patterns through the through holes at the surface of circuit board.

(2) A multilayered printed circuit board according to claim 1, wherein said modification patterns are provided at the intenal layer nearest to the surface of circuit board.

(3) A multilayered printed circuit board according to claim 2, wherein a through hole used for connecting said modification patterns and modification bonding pads are blind through holes.

(4) A multilayered printed circuit board according to claim 3, wherein said modification bonding pad is provided near the bonding pad to which circuit parts lead terminal is connected.

(5) A multilayered printed circuit board according to claim 3, wherein said modification patterns are connected in series through a plurality of the blind through holes and modification bonding pads.

*Fig. 1*

Fig. 2A

Fig. 2B

0203203

Fig. 3

Fig. 4A

Fig. 4B

LIST OF REFERENCE SYMBOLS

1a, 1b.....LSI

3a, 3b, 3e, 3f, 3g, 3h.....bonding pad

4g, 4h.....leadout pattern

5a,5b,5e,5f.....through hole

6.....modification pattern

8.....printed circuit board

9.....internal layer pattern

11a, 11b.....leadout wire

# INTERNATIONAL SEARCH REPORT

International Application No. PCT/JP85/00660

| I. CLASSIFICATION OF SUBJECT MATTER (if several classification symbols apply, indicate all) [3] |
|---|
| According to International Patent Classification (IPC) or to both National Classification and IPC |
| Int.Cl [4]     H05K 1/02, H05K 3/46 |

## II. FIELDS SEARCHED

| Minimum Documentation Searched [4] | |
|---|---|
| Classification System | Classification Symbols |
| IPC | H05K1/02, H05K 3/46 |

| Documentation Searched other than Minimum Documentation to the Extent that such Documents are Included in the Fields Searched [5] |
|---|
| Jitsuyo Shinan Koho          1960 - 1984<br>Kokai Jitsuyo Shinan Koho    1971 - 1984 |

## III. DOCUMENTS CONSIDERED TO BE RELEVANT [14]

| Category* | Citation of Document, [16] with indication, where appropriate, of the relevant passages [17] | Relevant to Claim No. [18] |
|---|---|---|
| Y | JP, Y2, 59-769 (Fujitsu Limited),<br>10 January 1984 (10. 01. 84)<br>(Family: none) | 1 - 5 |
| Y | JP, B2, 55-2913 (Fujitsu Limited),<br>22 January 1980 (22. 01. 80)<br>(Family: none) | 1 - 5 |

* Special categories of cited documents: [16]

"A" document defining the general state of the art which is not considered to be of particular relevance

"E" earlier document but published on or after the international filing date

"L" document which may throw doubts on priority claim(s) or which is cited to establish the publication date of another citation or other special reason (as specified)

"O" document referring to an oral disclosure, use, exhibition or other means

"P" document published prior to the international filing date but later than the priority date claimed

"T" later document published after the international filing date or priority date and not in conflict with the application but cited to understand the principle or theory underlying the invention

"X" document of particular relevance; the claimed invention cannot be considered novel or cannot be considered to involve an inventive step

"Y" document of particular relevance; the claimed invention cannot be considered to involve an inventive step when the document is combined with one or more other such documents, such combination being obvious to a person skilled in the art

"&" document member of the same patent family

## IV. CERTIFICATION

| Date of the Actual Completion of the International Search [2] | Date of Mailing of this International Search Report [2] |
|---|---|
| February 19, 1986 (19. 02. 86) | March 3, 1986 (03. 03. 86) |
| International Searching Authority [1] | Signature of Authorized Officer [20] |
| Japanese Patent Office | |

Form PCT/ISA/210 (second sheet) (October 1981)